# EUROPEAN PATENT APPLICATION

(11) **EP 0 638 998 A1**
(43) Date of publication of application: **15.02.1995**
(21) Application number: 94305659.8
(22) Date of filing: 29.07.1994
(51) Int. Cl.: H03G 3/20, H03G 1/04

(54) **Fast-acting automatic gain control arrangement**

(30) Priority: 11.08.1993 GB 9316681
(71) Applicant: PLESSEY SEMICONDUCTORS LIMITED, Swindon, Wiltshire SN2 2QW (GB)
(72) Inventor: Chadwick, Peter Edward, Braydon, Swindon SN5 0AD (GB)
(74) Representative: Hoste, Colin Francis

(57) **Abstract**

A fast-acting automatic gain control arrangement comprises a gain-controlled amplifier stage (35), a detector stage (34) and a time delay means (33). The amplifier stage and detector stage are both fed in parallel from an input signal and the output of the detector stage is used to adjust the gain of the amplifier stage. The time delay means is included in series with and upstream of the amplifier stage. Means may be included in the control circuit to modify (e.g linearise) the transfer function of the gain-control function, and this may include provisions for inputting an external modifying signal. The detector is preferably a successive logarithmic amplifier to ensure that the automatic gain control arrangement can handle a wide input dynamic range.

## Description

The invention concerns a fast-acting automatic gain control arrangement, in particular a fast-acting automatic gain control arrangement for use in electronic and communications systems in which there is a requirement to amplify signals of a wide dynamic range.

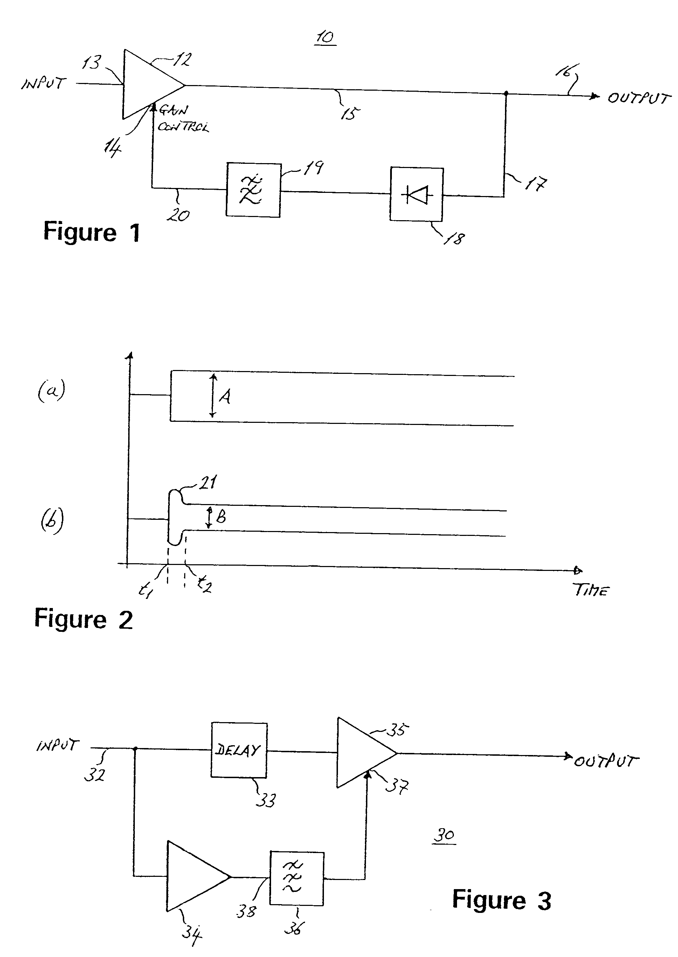

Amplifier systems used in fields such as radiocommunications, radar, instrumentation, electronic control systems, broadcasting, etc, often need to be able to handle input signals of wide dynamic range, while outputting signals at a substantially constant level. In computer and other communication systems where a CSMA (Carrier Sense Multiple Access) protocol system is used, it is important that a receiver be able to receive a strong or a weak signal without overloading and be able rapidly to adjust to level variations in order to minimise the effective deadtime of a network. Techniques for doing this go under the general name of Automatic Gain Control (AGC) and are already well established in the art. One of the most commonly used forms of AGC is the arrangement shown in Figure 1.

In Figure 1, an AGC stage 10 is based around a gain-controlled amplifier 12. The gain-controlled amplifier 12 has two inputs: a signal input 13 and a gain-control input 14. The gain-control input 14 is arranged to modify the gain of the amplifier 12 in accordance with the value of a signal appearing on the gain-control input 14. The output of the amplifier 12 is taken along a line 15 to form, firstly, the output 16 of the AGC stage and, secondly, a feedback loop 17 consisting of a rectifier (detector) 18 and a low-pass filter 19. The detected and filtered output signal is passed along a line 20 to the gain-control input 14 of the amplifier 12.

The operation of the AGC stage is as follows. It is first assumed that the signal on the input 13 is initially zero, or of very low amplitude (see Figure 2). At a time t₁, the input signal rises sharply to a peak-to-peak value of *A* volts (see line (a) of Figure 2), which would result in an output signal on line 16 having an amplitude higher than desired. The AGC system acts to reduce the output signal level by feeding back a detected version of the output signal to the amplifier 12, using this fed-back signal to reduce the gain of the amplifier 12. Thus the output of the amplifier 12 takes the peak-to-peak value B, as shown in line (b) of Figure 2. In order for the AGC system to work properly and to avoid signal distortion in the amplifier 12, the filter 19 is arranged to have a low enough cut-off point, i.e. a long enough time constant, to ensure that the feedback signal on line 20 represents the average value of the output signal, not the instantaneous value. The result of this is that it takes a finite time for the AGC system to respond to a sudden rise in input signal level, and consequently the amplifier at first overloads if the input signal is large enough. This is shown as the overshoot 21 in Figure 2. The time taken to respond is known as the "attack time" and this corresponds to the time t₂ - t₁ in Figure 2.

While it is possible to arrange for the attack time to be short, this is in practice difficult to implement. Further, the phase shift that occurs within the amplifier, as the gain is varied, and within the filter 19 at frequencies represented by the envelope variations can lead to instability in such known systems.

It would be desirable to provide an automatic gain control arrangement which overcomes or mitigates the above problems associated with the known arrangements.

According to the invention, there is provided a fast-acting automatic gain control arrangement comprising a gain controlled amplifier means having a signal input, a gain-control input and an output which constitutes an output of the automatic gain control arrangement, and a detector means having an output which drives the gain-control input of the gain-controlled amplifier, characterised in that the signal input of the gain-controlled amplifier is connected to an input of the detector means, and in that a time delay means is connected between the input of the detector means and the signal input of the gain-controlled amplifier means.

The AGC is effectively carried out in open-loop, which has the advantage of removing the undesirable time delays and phase shifts created by the closed loop arrangement of the conventional gain-control system. This is of particular benefit where the invention is used, for example, within a communications or computer network utilising a modulation scheme with an appreciable amplitude-modulated component, as in, for instance, Direct Sequence Spread Systems. In such systems, the invention allows for shorter times to be implemented during which the system is unable to receive data because amplifier stages are settling following the receipt of a large input signal. However, a trade-off of such a gain-control arrangement is the lack of absolute constancy in the output signal level, due to the fact that the linearity of the AGC action is necessarily made dependent on the transfer characteristic of the gain-control mechanism. The use of a time delay has the advantage that it ensures that an appropriate gain-adjusting signal is present on the gain-control input of the gain-controlled amplifier before a high-amplitude input signal sends the gain-controlled amplifier into overload.

The delay means may take a number of forms, e.g. an inductive/capacitive delay line, a length of transmission line of suitable characteristic impedance and velocity factor, or a digital circuit with suitable interfaces to the input signal and the gain-controlled amplifier.

The automatic gain control arrangement may comprise modifying means for modifying the control characteristic of the automatic gain control arrangement. This may be necessary, in practice, to linearise the performance of the ACG system, as mentioned above, or to trim the gain-control characteristic to any desired performance, not necessarily linear.

The modifying means may comprise an analogue-to-digital converting means, a memory means having an address input and a data output, and a digital-to-analogue converting means, an input of the analogue-to-digital converting means being connected to the output of the detector means, an output of the analogue-to-digital converting means being connected to the address input of the memory means, the data output of the memory means being connected to an input of the digital-to-analogue converting means, and an output of the digital-to-analogue converting means being connected to the gain-control input of the gain-controlled amplifier means. The memory means is preferably realised as a read-only memory (ROM).

The use of such a memory means allows, for example, a linearly changing signal level at the input of the automatic gain control arrangement to be converted into a non-linearly changing set of digital values at the data output of the ROM, these values being, in turn, converted into a corresponding set of non-linearly changing analogue values for application to the gain-control input of the gain-controlled amplifier. In this way, the gain-control transfer function of the system may be appropriately modified, e.g. linearised, where the transfer function is not already linear.

Advantageously, the modifying means may comprise means for receiving an external modifying signal. In the case where the modifying means employs a memory means such a ROM which outputs digital data, the means for receiving an external modifying signal may comprise a digital adder, a first input of which is arranged to receive an external modifying signal and a second input of which is connected to the data output of the memory means, an output of the digital adder being connected to the input of the digital-to-analogue converting means.

As an alternative to employing a digital adder, a multiplying input of the digital-to-analogue converting means may be employed to receive an external analogue modifying signal, the multiplying input being arranged to scale the data output of the memory means, the scaled data being then passed on to the gain-control input of the gain-controlled amplifier means. This has the advantage of reducing the amount of hardware needed to implement the automatic gain control arrangement.

As an alternative to the use of digital techniques, a purely analogue implementation may be employed, the modifying means then comprising an analogue adder, a first input of which is arranged to receive an external modifying signal and a second input of which is connected to the output of the detector means, an output of the analogue adder being connected to the gain-control input of the gain-controlled amplifier means.

The detector means may be realised as a successive detection logarithmic amplifier, the output of the detector means being constituted by the logarithmically amplified and detected output of the successive detection logarithmic amplifier, or it may be realised as a true logarithmic amplifier followed by a separate detector stage.

Use of a logarithmic amplifier, especially a successive detection logarithmic amplifier, gives rise to input signal compression, thereby allowing the automatic gain control arrangement of the invention to be employed where the input signal has a wide dynamic range, The successive detection logarithmic amplifier is also very fast and serves to speed up the response of the gain-control arrangement. Other types of amplifier may, however, be used, e.g. a linear amplifier.

The gain-control input of the gain-controlled amplifier means may be configured as a differential (push-pull) input. The advantage of this is that any leakage of the gain-control signal to the input or output of the gain-controlled amplifier means, which may have the effect of modulating the envelope of the signal being amplified, is balanced out.

A filter means, preferably constituted as a low-pass filter, may be connected in series with the output of the detector means.

The invention will now be described, by way of example only, with reference to the drawings, of which:
Figure 1 is a schematic diagram of a known AGC arrangement;
Figure 2 is a diagram showing the gain-control action of the arrangement of Figure 1;
Figure 3 is a schematic diagram of a first embodiment of the automatic gain control arrangement according to the invention;
Figure 4 is a schematic diagram of a successive detection logarithmic amplifier used in the various embodiments of the invention;
Figure 5 is a schematic diagram of a second embodiment of the automatic gain control arrangement according to the invention;
Figure 6 is a schematic diagram of a third embodiment of the automatic gain control arrangement according to the invention;
Figure 7 is a schematic diagram of a fourth embodiment of the automatic gain control arrangement according to the invention;
Figure 8 is a schematic diagram of a fifth embodiment of the automatic gain control arrangement according to the invention.
Figure 9 is a schematic diagram showing the use of differential gain control in the automatic gain control arrangement according to the invention.

Figure 3 shows a automatic gain control arrangement according to a first embodiment of the invention, in which a signal to be amplified is taken along a line 32 to a delay means 33 and to a detector means 34. The output of the delay means 33 feeds the signal input of a gain-controlled amplifier 35, while the output of the detector means 34 is filtered in a filter means 36 and subsequently taken to the gain-control input 37 of the gain-control amplifier 35. The filter means 36 is a low-pass filter which provides a signal at the input 37 representative of the average value of the signal at its input 38. The delay means may be a length of tranmission line, a lumped inductance/capacitance line, etc.

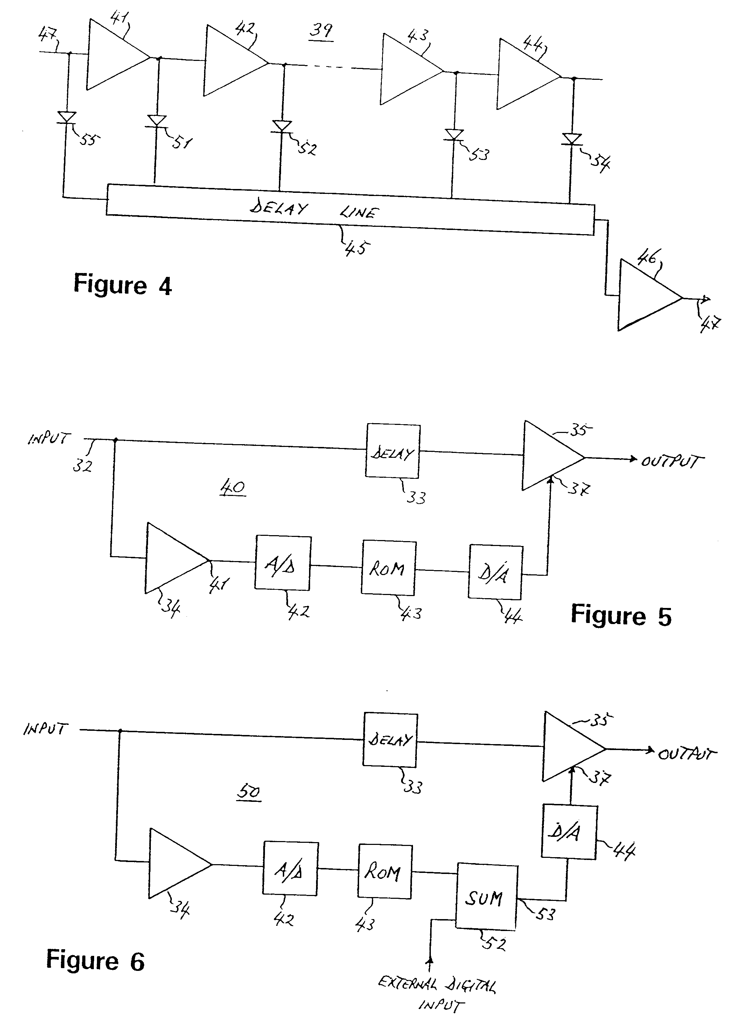

The detector means 34 consists of a successive detection logarithmic amplifier (log amp), the construction of which is shown in Figure 4. The successive detection log amp 39 shown in Figure 4 consists of a number of cascaded linear, limited amplifier stages of which four, stages 41-44, are shown. The outputs of the amplifier stages are detected in detectors 51-54, and the input of the whole log amp is also detected in a detector 55. The outputs of the detectors are taken to a series of tappings on a delay line 45 where the outputs are summed, the summed output of the delay line being taken to a video amplifier 46, the output 47 of which represents the main output of the log amp. The log amp 39 is arranged so that as the level of its input signal rises, first the detector 54 comes into play, then detector 53, then detector 52, and so on. As each detector becomes active, the amplifier feeding the previously active detector starts to limit, the result being, at the output 47 of the log amp, a signal whose amplitude rises as the logarithm of the amplitude of the input signal. Because the transfer function of the log amp is a composite of the individual transfer functions of the individual amplifier stages, the composite being an approximate straight line where output voltage is plotted against input power, the log amp can handle input signals of a very wide dynamic range, e.g. 100 dB.

The automatic gain control arrangement shown in Figure 3 works as follows:

When the input signal on line 32 suddenly grows in amplitude, for example due to a transmitter just having been switched on, this rise in amplitude is amplified and detected in the detector means 34, low-pass filtered in the filter means 36 and used to decrease the gain of the amplifier 35. However, due to the presence of the delay means 33, the amplifier 35 has not yet registered the increase in input signal level, with the result that when the input signal does finally reach the amplifier 35, the gain of this amplifier has already been adjusted to the required level and the amplifier 35 does not overload due to the input signal rise.

Because the gain control of the invention is open-loop, not closed-loop, the level to which the output signal of the amplifier 35 settles is to some extent unpredictable; it depends, in fact, on the transfer function of the successive detection log amp 34 and on the output voltage versus gain-control voltage characteristic of the amplifier 35. These may have quite wide tolerances, even when they are known. Apart from tolerances inherent in these transfer functions, the transfer functions may in themselves be non-linear, as indeed that of the detector means 34 is, in this embodiment, since a successive detection log amp is being used here. Because of this, a second embodiment of the invention introduces modifying means to effect a linearisation of the gain-control characteristic .

The second embodiment is illustrated in Figure 5. In this embodiment, an automatic gain control arrangement 40 comprises, in addition to the elements shown in Figure 3, an analogue-to-digital converter (A/D) 42, a ROM 43 and a digital-to-analogue converter (D/A) 44. For simplicity, the filter means 36 is not shown, but it should be understood to be present. The increased signal level present on the input line 32 appears on the successive detector log amp output 41, is digitised in the A/D converter 42 and then passed on, in digital form, to the address input of a ROM 43. The ROM contains a number of storage sites corresponding to the number of discrete levels in the A/D 42, and a value stored in the site corresponding to the particular analogue voltage on the input of the A/D 42 is output from the data output of the ROM 43, converted back into analogue form in the D/A converter 44 and applied as the gain-control voltage at the input 37 of the amplifier 35. The transfer function of the ROM will be roughly antilogarithmic to compensate for the compressing action of the log amp 34, but will be tailored to compensate also for any irregularities (deviations from linearity) in the gain-control transfer function of the amplifier 35. The gain-control branch in this embodiment acts as a compander, the log amp 34 compressing the input signal and the ROM 43 expanding it again.

In data transmission systems, it may be desirable to modify the gain and/or phase characteristics of an amplifier frequently to compensate for an imperfect transmission medium. An example of this is where multipath propagation is experienced in transmission, the effect being the arrival of several signals spaced apart in time at a receiving antenna. The superposition of such staggered signals causes amplitude and phase distortions, and it is desirable to be able to compensate for such distortions.

To cater for this, a third embodiment of the invention, shown in Figure 6, incorporates a digital adder 52 into a gain-control arrangement 50, which essentially comprises the same elements as the arrangement 40 of the second embodiment. Now the data output of the ROM is combined with an external digital input signal to provide a signal at the output 53 of the adder 52 which varies in amplitude with the external signal. The summed signal is converted, as before, into an analogue signal and applied to the input 37 of the amplifier 35.

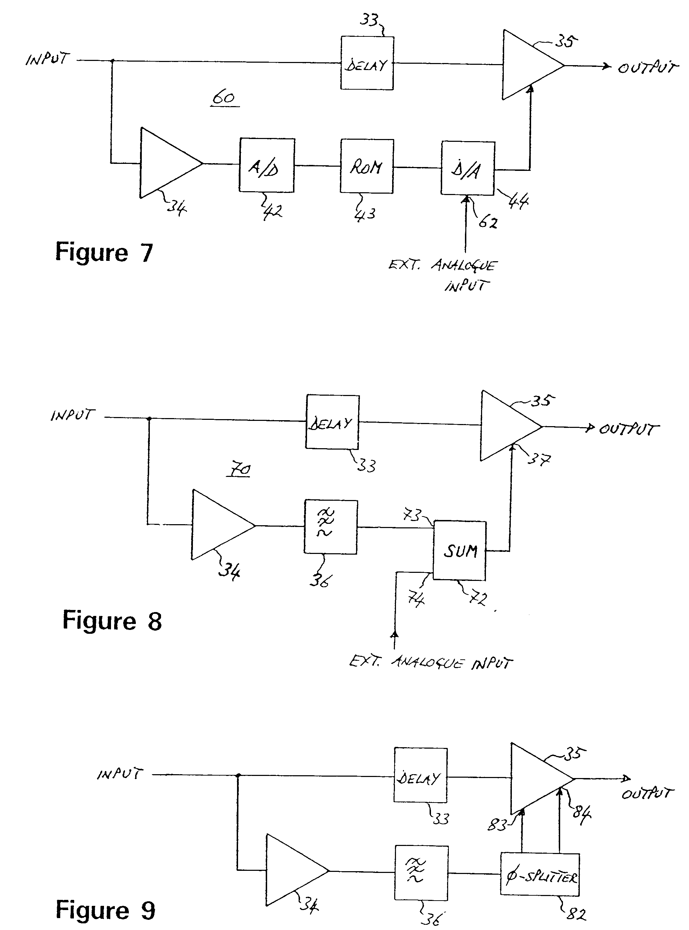

As an alternative to employing a digital adder, use may be made of a multiplying input of the D/A converter to provide access for the external modifying signal to the gain-control arrangement. This, a fourth embodiment, is shown in Figure 7. In Figure 7, an automatic gain control arrangement 60 is configured exactly as the arrangement 40 of Figure 5, except that this time an analogue scaling input 62 of the D/A converter 44 is used to receive an external analogue signal.

Finally, a fifth embodiment of the invention utilises purely analogue techniques to achieve a automatic gain control arrangement modifiable solely by an external signal. The gain-control arrangement 70 of this embodiment, shown in Figure 8, is configured exactly as the basic embodiment of the invention shown in Figure 3, but with the addition of an analogue adder 72. The adder 72 combines additively the detected, filtered signal on its input 73 with an external analogue signal on its other input 74, the sum signal being taken directly, in analogue form, to the gain-control input 37 of the amplifier 35.

In order to minimise the effects of feedthrough of the gain-control signal on the input 37 of amplifier 35 to the input or output stages of the amplifier 35, a differential gain-control input configuration may be used. This is shown in Figure 9, where the basic embodiment of Figure 3 includes a phase-splitter stage 82 feeding two gain-control inputs 83, 84 in the amplifier 35. The two outputs of the phase-splitter 82 are in anti-phase and so any charge leakage and out-of-balance input currents caused by either one of the gain-control inputs 83, 84 are cancelled out.

This push-pull technique may be employed in any of the embodiments described above.

## Claims

1. A fast-acting automatic gain control arrangement comprising a gain controlled amplifier means (35) having a signal input, a gain-control input (37) and an output which constitutes an output of the automatic gain control arrangement, and a detector means (34) having an output which drives the gain-control input (37) of the gain-controlled amplifier, characterised in that the signal input of the gain-controlled amplifier (35) is connected to an input of the detector means (34), and in that a time delay means (33) is connected between the input of the detector means (34) and the signal input (37) of the gain-controlled amplifier means (35).

2. A fast-acting automatic gain control arrangement as claimed in Claim 1, characterised in that the time delay means (33) is constituted by a delay line.

3. A fast-acting automatic gain control arrangement as claimed in Claim 2, characterised in that the delay line is a lumped inductance/capacitance delay line.

4. A fast-acting automatic gain control arrangement as claimed in Claim 2, characterised in that the delay line is a length of transmission line.

5. A fast-acting automatic gain control arrangement as claimed in any one of the preceding claims, characterised by modifying means (42, 43, 44, 72) for modifying the control characteristic of the automatic gain control arrangement.

6. A fast-acting automatic gain control arrangement as claimed in Claim 5, characterised in that the modifying means comprises an analogue-to-digital converting means (42), a memory means (43) having an address input and a data output, and a digital-to-analogue converting means (44), an input of the analogue-to-digital converting means (42) being connected to the output of the detector means (34), an output of the analogue-to-digital converting means (42) being connected to the address input of the memory means (43), the data output of the memory means (43) being connected to an input of the digital-to-analogue converting means (44), and an output of the digital-to-analogue converting means (44) being connected to the gain-control input (37) of the gain-controlled amplifier means (35).

7. A fast-acting automatic gain control arrangement as claimed in Claim 6, characterised in that the memory means (43) is a read-only memory.

8. A fast-acting automatic gain control arrangement as claimed in any one of Claims 5 to 7, characterised in that the modifying means comprises means for receiving an external modifying signal (52, 62, 72).

9. A fast-acting automatic gain control arrangement as claimed in Claim 8 and Claim 6, characterised in that the means for receiving an external modifying signal comprises a digital adder (52), a first input of which is arranged to receive an external modifying signal and a second input of which is connected to the data output of the memory means (43), an output of the digital adder (52) being connected to the input of the digital-to-analogue converting means (44).

10. A fast-acting automatic gain control arrangement as claimed in Claim 8 and Claim 6, characterised in that the means for receiving an external modifying signal comprises a multiplying input (62) of the digital-to-analogue converting means (44), the multiplying input (62) being arranged to scale the data output of the memory means (43), the scaled data output being passed on to the gain-control input (37) of the gain-controlled amplifier means (35).

11. A fast-acting automatic gain control arrangement as claimed in Claim 5 and Claim 8, characterised in that the modifying means comprises an analogue adder (72), a first input (74) of which is arranged to receive an external modifying signal and a second input (73) of which is connected to the output of the detector means (34), an output of the analogue adder being connected to the gain-control input (37) of the gain-controlled amplifier means (35).

12. A fast-acting automatic gain control arrangement as claimed in any one of the preceding claims, characterised in that the detector means (34) comprises a true logarithmic amplifier stage feeding a detector stage.

13. A fast-acting automatic gain control arrangement as claimed in any one of Claims 1 to 11, characterised in that the detector means (34) comprises a successive detection logarithmic amplifier, the logarithmic, detected output of the successive detection logarithmic amplifier serving as the output of the detector means (34).

14. A fast-acting automatic gain control arrangement as claimed in any one of the preceding claims, characterised in that the gain-control input (37) of the gain-controlled amplifier means (35) is a differential input (83, 84) and the gain-control signal is applied to the gain-control input in push-pull.

15. A fast-acting automatic gain control arrangement as claimed in any one of the preceding claims, characterised by a filter means (36) connected in series with the output of the detector means.

16. A fast-acting automatic gain control arrangement as claimed in Claim 15, characterised in that the filter means (36) is a low-pass filter.
